**Europäisches Patentamt**

**European Patent Office**

**Office européen des brevets**

(19)

(11) Publication number : **0 372 108 B1**

(12)

# EUROPEAN PATENT SPECIFICATION

(45) Date of publication of patent specification :
**31.08.94 Bulletin 94/35**

(51) Int. Cl.⁵ : **H01L 23/34, H01L 23/42, F25B 19/00, H01L 31/024**

(21) Application number : **88120335.0**

(22) Date of filing : **05.12.88**

(54) **Vacuum container for cryogenically cooled electron device packaging.**

(43) Date of publication of application :
**13.06.90 Bulletin 90/24**

(45) Publication of the grant of the patent :
**31.08.94 Bulletin 94/35**

(84) Designated Contracting States :
**DE FR GB IT NL**

(56) References cited :
**EP-A- 0 190 490**
**WO-A-88/01437**
**US-A- 4 059 764**

(73) Proprietor : **Diedrich, Heinz Karl**
**Via Scalpelli, 1**
**I-00019 Tivoli (RM) (IT)**

(72) Inventor : **Diedrich, Heinz Karl**
**Via Scalpelli, 1**
**I-00019 Tivoli (RM) (IT)**

## Description

The herewith presented invention regards a package for solid state electron devices which operate at temperatures in the cryogenic range from 10 to 150 degrees Kelvin.

Known are numerous classes of cryogenically cooled electron devices which suit a vast range of very different functional requirements.

Examples are parametric amplifiers as sensors for weak microwave signals, linear arrays of infrared detectors and superconductive magnetic sensors (SQID's). More recently, other devices have emerged which capitalise on advances in material growth and in energy band gap and lattice structure engineering. Cryogenically cooled digital and analogical IC's (e.g. MMIC's) employing high electron mobility transistor (HEMT) or heterojunction bipolar transistor (HBT) structures prove to be of extreme interest to the military/aerospace, computer and communications business worldwide. Ultra-fast active and passive superconductive ceramic components are developing. A great variety of staring mode infrared area arrays for thermal imagery or passive surveillance with integrated electronic scanning architectures are available or being developed.

High multifunction and integration complexity are characteristic of these devices. Monolithic and hybrid assembly technologies are applied on circuit boards with high numbers of input/output pads which need cold stations with uniform temperatures over large areas. Operational performance of some devices is very sensitive to temperature variations and these devices require exact and controlled temperature biasing.

Present-day packages for cryogenically cooled electron devices are penalised by basic, built-in shortcomings which limit their operational performance figures and often make them unfit for utilisation as reliable and at the same time relatively inexpensive mass products.

Improvements in the design and construction of these packages are therefore highly desirable with the ultimate objective to meet standards, comparable to those set by devices operating at room temperature and suited to mass production.

A class of cryogenic coolers, more typically used in practice, are closed cycle cryogenic engines which are 100 percent power loss devices with thermal efficiencies of about one percent or even much less. Heat loss must therefore be minimised and this requires the electron device be encapsulated in an evacuated embodiment.

Such a vacuum encapsulation is commonly designated as Dewar. It comprises a coldfinger member onto which the electron device is mounted in the inner evacuated portion of the encapsulation. The non-evacuated portion of the coldfinger is mechanically connected to a cryocooler. The cold tip of the cooler is in thermal contact with a small area of the wall of the coldfinger close to the device, thereby causing heat from the device in the interior to flow through a multi-layer structure comprising the wall of the coldfinger into the exterior cryogenic heat sink.

The package of the invention is of the Dewar type, and the invention concerns the cryogenic interface between the cooler and its thermal payload, the encapsulated electron device. The cryogenic interface is the source of some major disadvantages with which current Dewars are afflicted.

Many different Dewar versions have been proposed prior to the invention.

An illustrative example is a Dewar for multielement infrared detectors, US-A-4 206 354. Useful as it is for the specific applications in thermal imaging, it however shows severe limitations regarding its use for other applications: the cryogenic interface provides borosilicate glass as coldfinger wall material.

Glasses have high thermal resistivities and the temperature drop across the glass layer limits the use of the Dewar to devices with low heat payload or to those in which temperature non-uniformity or floating are acceptable.

Another similar Dewar, US-A-4 059 764, provides Kovar(TM) as coldfinger wall material which is a much better heat conductor than glass.

However, in both versions the heat path of the cryogenic interface comprises at least one layer of an organic resin such as epoxy between the coldfinger wall and the electron device. Epoxies are very poor heat conductors with thermal resistivities about ten times higher than that of glass.

The use of Kovar is therefore an improvement compared with the first version but it is not a solution for the problem of constructing a multi-purpose Dewar package which suits thermal requirements of the entire class of the aforementioned electron devices.

It is known that resins, cured at near-ambient temperatures, cause strong virtual leaks and are inconsistent with requirements for reliable, hard vacuum devices. Unpredictable virtual leak rates and total amount of released gas due to minute variations in resin composition from lot to lot make this material class highly detrimental for Dewar mass production purposes.

The use of epoxy is a consequence of an inherent technological weakness in the Dewar design.

It is well known to people skilled in the art of the above mentioned electron devices that their materials share particularly small expansion coefficients at lower temperatures and that in silicon and in many III - V and II - VI compound semiconductors and in their alloys thermal dilatation converges to zero with expansion coefficent inversion in the 100 to 50 K range. These peculiar properties make them suitable to for instance, epitaxially grown heterostructures with the known, outstanding applications in cooled devices but, on the other hand, cause dilatation mismatch to other materials such as glass or Kovar.

It is obvious that a joint consisting of materials with different thermal expansion coefficients necessitates intermediate layers between adjacent materials which absorb strains caused by thermomechanical mismatch when thermal cycling of more than 150 degrees occurs. A resin like epoxy offers adequate strain absorption properties and its use is therefore a consequence of the heretofore chosen wall material of the cryogenic heatpath.

This invention provides a technological solution to the dilemma of the concurrence of contradictory mechanical, thermal and chemical aspects by a vacuum container as set out in appended claim 1. It substitutes the heretofore used heatpath materials by silicon as a close match for electron devices and by introducing a silicon-to-glass technology which leads to a package and a construction process thereof, characterized by:
- vacuum integrity according to hard-vacuum device specification standards
- highest thermal conductance with low thermal loss between electron device and cryogen, uniform temperature distribution over the electron device on a large area cold station
- a concept of construction modulity resulting in high design flexibility, off-line assembly architecture, early reject identification and low production cost for mass production.

The detailed description of the invention is illustrated by and referred to the Figs 1 through 14.

Fig 1 is an on-scale drawing of a practical package in modular version

Fig 2 is the enlarged upper part, illustrating device mounting and interconnections

Fig 3 is the coldfinger module, referring to Fig 1

Fig 4 shows the details of the innovative cryogenic interface between electron device and coldfinger

Figs 5 and 6 exemplify different heat transfer configurations

Fig 7 illustrates the silicon-glass seal construction process

Figs 8 and 9 are examples of the mounting cold station suited to particular electron devices with higher assembly joining levels

Figs 10 and 11 illustrate a package version suited to open-cycle Joule Thompson coolers and the construction process thereof.

As apparently the best known material in solid state device technology, silicon characteristics data is commonly available.

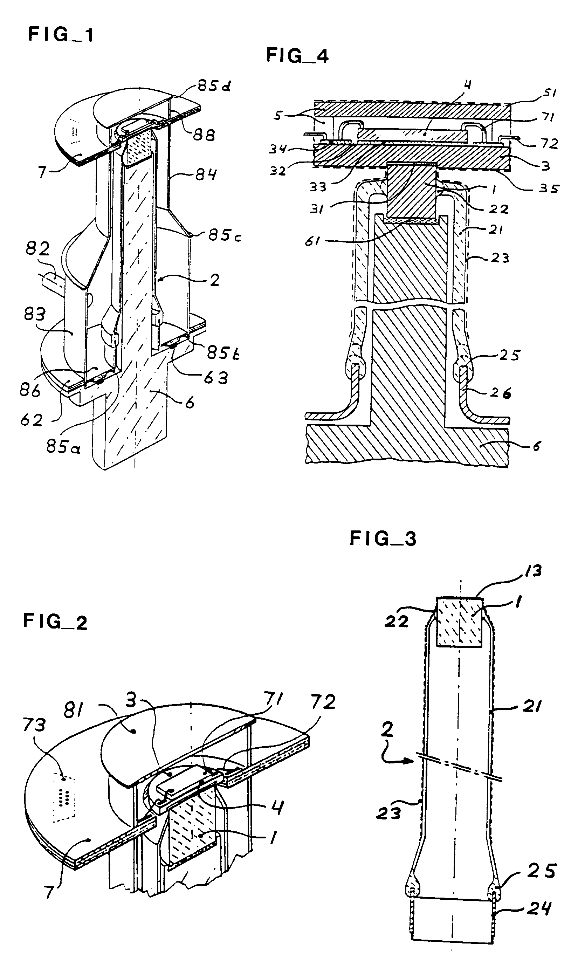

The following description of the package refers to Figs 1, 2, 3 and to Fig 4 which shows the innovative part of the invention in all details.

The illustrative example of the package, Fig 1, is built up from four assembly modules which are separately constructed, checked and qualified.

The tubular cold finger module 2, Fig 3, constitutes the central part around which the package is assembled coaxially. Its upper closed end comprises a cylindrical, rod-shaped heat transfer member 1 which is concentrically and hermetically sealed into a tubular glass member 21 of the coldfinger module. At the lower end of the coldfinger module the glass tube 21 is sealed to a metal tube 24.

The heat transfer member 1 is high-purity single crystal silicon which is an extremely good thermal conductor at low temperatures. It provides the heat path from the electron device 4 across a mounting base of silicon, the cold station 3, both situated in the evacuated portion of the embodiment, to the opposite outer surface thereof.

The metal tube 24 is joined to a cup-shaped metallic evacuation module, consisting of a bottom plate 86 and a tubular member 83 which comprises a radially extending evacuation tube 82 and three electrical feedthroughs for two incorporated re-activatable getters. Feedthroughs and getters are not shown in the figures. Feedthroughs and evacuation tube 82 are hermetically assembled with the tubular member 83 by means of well known brazing techniques and the components 24, 86 and 83 by laser welding at the rims 85a and 85b.

The upper part of the outer embodiment is the feedthrough module. It consists of the metallic tubular members 84 and 88. They are joined to the ring-shaped electrical feedthrough component 7 by means of a brazing process.

The feedthrough component carries a plurality, in the illustrative example of Fig 1 a number of 36, of inward to outward radially extending electrical leads for input/output signals, grounds, biasing and other auxiliary circuitry connections of the electron device 4.

The feedthrough ring 7 is a laminated and sintered metal/ceramic multi-layer stack. The multi-layer configuration, its construction procedure and its application in a vacuum tight Dewar for infrared detectors are fully described in EP-AB-0 058 645.

The electrical leads terminate in four groups of metallised through-holes, 73, compatible with pin centers of standard miniature connector plugs.

Feedthrough module and evacuation module are joined by laser welding at rim 85c.

The fourth module of the package is a metal cover 81 which is welded to the feedthrough module at rim 85d after electron device mounting on the coldfinger and after the inner wiring of interconnections to the feedthrough leads, before the evacuation process. For electron devices with optical inputs it accommodates a window with interferential and metal layers for spectral and spatial filtering.

Each of the assembly modules is a self-contained unit and is assignated to a specific technical function of the package. The modular approach enables package manufacture to be divided into parallel, autonomous production lines for each module with the advantages of having transparent process flow chart breakdown & organisation and of allowing early failure identification & rejection on sub-assembly construction level.

The coldfinger construction refers to Figs 3, 4 and 7. Starting material for the heat transfer element 1 is an as-cut, (111) oriented, single crystal silicon slice of standard production diameter. Slice thickness is 8 mm. Cylindrical rods of 7 mm diameters are shaped ultrasonically.

Heat propagation in silicon is carried by the phonon-field and lattice imperfections of any kind cause phonon-scattering which reduces thermal conductivity. High-quality, high-purity silicon is therefore favourable but the quantitative specification depends on thermal requirements of the specific electron device. For most purposes the following characteristics are satisfactory: low dislocation density, "etch pit free" quality; majority impurity concentration of about $1 \times 10^{14}$ cm$^{-3}$ or less; boron-doped P-type or phosphorus-doped N-type silicon. These materials are standard for silicon device mass production.

Table I shows indicative values of thermal conductivity lambda in watts per cm degree and thermal resistance R in degrees per watt of the 8 mm/7 mm rod for various temperatures.

TABLE I

| degrees K | 10 | 20 | 30 | 50 | 70 | 100 | 150 |
|---|---|---|---|---|---|---|---|
| Lambda | 20 | 45 | 45 | 27 | 16 | 8 | 2,6 |
| R | 0.1 | 0.04 | 0.04 | 0.08 | 0.13 | 0.26 | 0.8 |

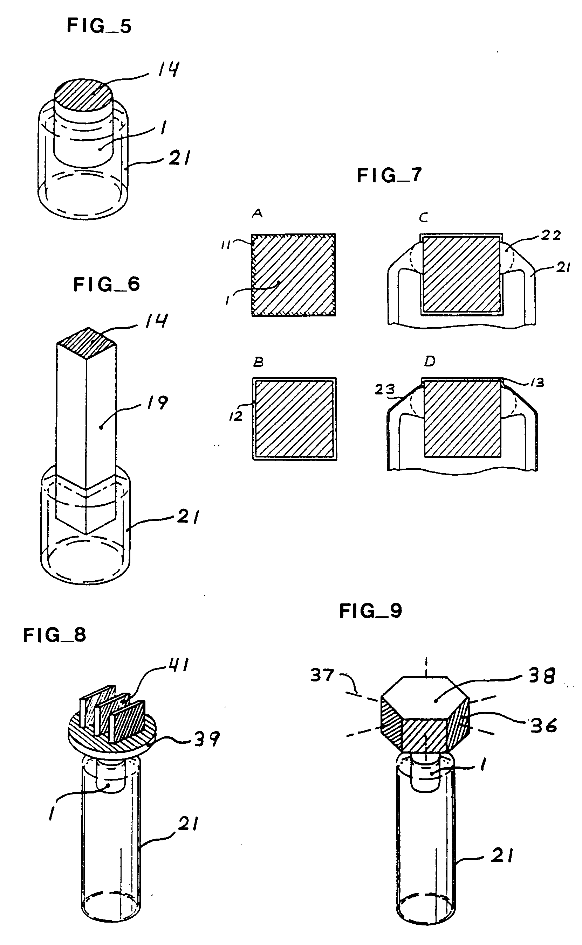

Fig 7 illustrates the glass-silicon sealing process. The mechanically damaged surface layer 11, Fig 7A, is chemically removed by a standard etch solution as for instance: HF - $HNO_3$ - $CH_3COOH$, 1 : 2 : 1 or HF - $HNO_3$, 1 : 1 plus some drops of $H_2SO_4$. Complete removal is important to avoid vacuum leakage in the glass seal along microcracks and thermal conductance deterioration caused by the formation of dislocation lines or slip planes generated at the damaged surface and extending into the inner of the rod during the high-temperature sealing process.

The next step is the growth of a 0.3 micron silicon oxide layer, Fig 7B, 12, by standard thermal oxidation.

The sealing process is performed in accordance with the art of glass-to-metal seal construction and no special facilities and tools are needed. The seal is made on a glass working lathe. For axial alignment the rod 1 is positioned on a quartz vacuum chuck. Wall thickness of tube 21 is 0.5 mm. The glass of seal 22 is canary glass, Corning code 3320 or Pyrex, Corning code 7740. The glass type of tube 21 depends on the tube 24 material. For Kovar (Vacon), it is made of Kovar glass, Corning code 7052, with canary glass as the seal 22 material.

For Fe Ni Cr steels like st.st. 304, the combination: seal 22/tube 21/seal 25 is entirely Pyrex(TM) where provisions have to be made for proper shape of the tube 24 according to Housekeeper's rules for non-matched glass metal seals.

Technical characteristics of the glasses are of common knowledge. Obviously, other equivalent glass types can be used such as the Schott glass Duran 8330(TM) instead of Pyrex. It is also obvious to choose other sealing combinations like silicon/Pyrex for seal 22 and tube 21/two layer graded seal 25/Kovar.

The oxide layer 12 at the joint of 22 is completely dissolved in the liquid glass. The exposed silicon oxide in the inner of tube 21 is etched off in a standard chemical solution and the coldfinger configuration is completed by sealing the tube 24 to tube 21.

The annealing schedule is: Cooling rate of 1 degree per minute from a temperature slightly above the annealing point (An. P.) to the strain point (St. P.) of the seal 22 glass. Holding time is 15 hours at St. P. Cooling time is 1 degree per minute down to St. P. of the softer, seal 25 glass. Example for the combination canary (a) and Kovar (b) glasses: An. P. (a) is 540, St. P. (a) is 493, St. P. (b) is 436°C.

A pickling process on tube 24 is followed by a 100 percent thermal shock out-process test. Procedure: dip upper part of coldfinger including rod 1, seal 22 and part of tube 21 into liquid nitrogen. Repeat 10 times. Perform helium leak test before and afterwards. Condition: leak rate less than $10^{-11}$ std. He.

An additional shock test is performed on rod 1/seal 22/tube 21 samples: heat up samples to 473 K, quench by dropping them into liquid nitrogen (77 K). Samples must be crack-free and leak-tight.

The remarkably high stability of the silicon-glass seals against most severe thermal stresses has been empirically found on test samples with up to 10 cm (four inches) diameters. Thermal contraction figures of silicon and the used glasses predict the glass-to-silicon joint a quite well matched seal down to ambient temperatures and a compression seal at low temperatures. Metal-glass compression seals are known as thermally very strong joints.

The calculated high tangential tensile stress in the glass seal suggests the ring width of the seal 22 to be kept small and anyway, not larger than the empirically corroborated value of about 2.5 mm for a 0.5 mm thick tube wall.

Concerning the high adhesion strength at the glass-silicon interface, it is believed that the borosilicate glass liquid substitutes the native silicon oxide layer at the fresh silicon surface by forming essentially the same strong oxygen-silicon bonds.

The coldfinger is outgassed at 350 degrees C for 2 hours in dry air. Further to surface cleaning, this process also aims at out-diffusing the vacuum contaminant helium which is penetrated into the glass bulk during preceding leak tests. The degassed glass and the silicon rod surfaces which will be exposed to vacuum in the package are then sealed off by a sputter deposited layer 23, Fig 7D, of 0.6 $\mu$m nichrome and 0.1 $\mu$m gold.

Virtual leak sources are thereby practically eliminated and at the same time, the non-oxidised metal layer, thanks to its minimum absorption coefficient, reduces thermal losses via radiation absorption to only a very small fraction of its value for a glass surface. Nichrome has high thermal resistivity which keeps parallel conduction heat loss along the coldfinger tube wall low. Gold protects the nichrome against oxidation during the subsequent package and electron device assembly steps.

On-sputtered gold, 0.5 $\mu$m is added on top of rod 1. This layer 13 is the solder contact area for cold station assembly.

Feasible are various physical forms of the heat transfer element. The Fig 6 shows an execution of the silicon-glass configuration with a squared bar 19 instead of the cylindrical rod 1 heat transfer body of Fig 5. For length/diameter ratios much greater than one, mechanical shaping by drilling is difficult and expensive and the heat transfer element is cut from the silicon slice. It is essential to round the edges chemically before glass sealing by etching at least 50 $\mu$m off the plane side surfaces.

High-purity single crystal silicon is highly transparent in the thermal infrared so reflection coating against radiation absorption is not critical. Metallisation can be performed by simple electroless plating techniques.

The electron device/cold station assembly is mounted on area 14 which is distant from the cooler 6 of Fig 1. This is advantageous where close vicinity of for instance EMI sources or ferromagnetic materials penalise operational performance. For a heat transfer element of 40 mm length and same cross-section as before, thermal resistance is still below 0.5 degrees per watt at 50 K.

Coldfinger, evacuation and feedthrough modules of the package are assembled according to the previous package description.

The cold station 3, Figs 2 and 4, substrate for the electron device chip 4, is constructed from single crystal silicon and as such it is not only a mechanical carrier but it is also an integral part of the assembled electron device. The double function as thermal conductor and as a base suited to accommodate integrated hybrid or monolithic passive and active planar components, makes the use of silicon particularly attractive.

The following construction procedure is an illustrative example of the simplest structure without integrated electronic components. No details will be given to construction elements, obvious in the art of technological silicon processing and emphasis will be placed on the thermal aspect only.

The cold station 3 in Fig 2 is a 2 mm thick disc of 10 mm diameter. Silicon material characteristics are usually the same as for the heat transfer element. Its front surface is polished and thermally oxidised, 32. Its back face provides an alignment seat for heat transfer element mounting. The entire surface is sputter metallised with titanium-palladium-gold, 35, and a pattern of conductor lines 34 and solder pad 33 is photolithographically and chemically delineated on the front face.

For cold stations with integrated components like in-diffused conductor lines, PN-junctions, MOS structures or others, higher P or N type bulk impurity levels are often preferable. Highly doped silicon exhibits higher thermal resistance but its use is not prohibitive if proper choice for the specific device requirements is made. For example, estimated thermal resistances for an impurity concentration of $4 \times 10^{16}$ per $cm^3$ and for the physical dimensions of 3 in Fig 2, are less than 0.05 degrees per watt in the range from 20 to 100 K where most of the cryogenically cooled electron devices operate and at 10 and 150 K it is 0.2 and 0.1 degrees per watt, respectively.

Provided thermal compatibility, cold station design flexibility is therefore practically only limited by constraints in the current art of silicon device fabrication and by economical trade-off considerations.

The metallised device chip 4 is soft soldered on the pad 33 and its electrical terminals are gold bonded, 71, to the conduction lines 34. In Fig 2 only two terminals on chip 4 are shown. The assembly 3 & 4 is electrically checked and then soft soldered, 31, on the heat transfer element 1 of the coldfinger module 2. Non-pure eutectic alloys for minimum fatigue joints are commercially available and joining techniques are of common knowledge. Thermal resistance of a metal layer joint is of the order of 0.1 degrees per watt and per $cm^2$ for 100 $\mu$m thickness for more typical solders. Layer thicknesses must therefore be kept small. Not shown on the cold station 3 in Figs 2 and 4 are two transistor 2N 2222 dice with the emitter-base diodes used as sensors for temperature monitoring and cold power supply feedback control.

The interconnection wires 72 bridge electrically and thermally the gap between cold station 3 and feedthrough component 7. The connectors 72 are 60/40 copper-nickel, 12 $\mu$m thick and 60 $\mu$m wide rolled wires with high mechanical strength and flexibility. They are bonded to the inner, 34, and outer conductor lines by parallel-gap or stitch welding. Conductive thermal loss is 0.5 mW per wire and electrical resistance is 2.5 ohm for a length of 5 mm. Much lower electrical resistances are obviously feasible but inherently at the expense of proportionally higher thermal losses.

A flange 62 is mounted around the embodiment member 83. The body 6 is the expander of a 0.5 watt split cycle Sterling cooler. It is clamped to flange 62 and is vacuum tightened by O-ring seal 63. A stack of flexible copper wire mesh spacers 61 provides the thermal contact between cooler 6 and heat transfer element 1. In another version, the wire mesh spacers are of Nylon. During the first cool down phase, the cooler works at zero load with maximum speed. When reaching the boiling point of the surrounding gas, the heat exchange is carried by the turbulent convection of the precipitated, liquified gas in the Nylon mesh. This latter version is particularly advantageous for electron devices with thermal bias ranging from boiling point at N.P. to triple point of gasses like nitrogen, oxygen, argon or neon. The space between coldfinger 2 and cooler 6 is filled with the appropriate gas.

The package design of the invention can be shaped to many particular electron devices. The following shows three illustrative examples of how to benefit from combinations of the unique features of silicon material.

1     Fig 4 shows a cold shield 5 made of high purity, appropiately shaped silicon. It is soldered onto the upper face of cold station 3 by a not shown metal layer and covered with a reflection layer 51, thereby providing a virtually isothermal encapsulation even in the presence of strong thermal radiation, useful for devices which are sensitive to minute temperature variations.

Physical dimensions are not given here because they are largely up to the designer, keeping in mind that heat conduction in silicon at 70 K is four times that of copper at room temperature and is even much higher at lower temperatures (see Table 1).

In general, design must take into account that for a silicon component with very small linear dimensions, thermal conduction is reduced by phonon-scattering at the surfaces.

2     Fig 8 illustrates a cold station/cold finger unit for cooled electron devices of high multifunction and VLSI complexity. The three silicon substrates 41 carry a set of IC chips and discrete components which are interconnected by not shown first and second assembly level joints. The substrates are mechanically and thermally contacted to the silicon motherboard 39 which is cooled through heat transfer rod 1. A low resistivity layer allows placement of the ground level on the back of each substrate with contact made from the front through the silicon. A motherboard disc 39 with 40 mm diameter and 4 mm thickness is sufficient for at least 20 $cm^2$ area for cooled electron circuitry accommodation.

3     Fig 9 shows a cryogenic mounting basis for staring mode, panoramic infrared surveillance. Cold station 38 is a hexagonal silicon block. Areas 36 allow for monolithic IRCCD focal plane array mounting of for instance the Ir Si - Pt Si - $Pd_2$ Si Schottky barrier or the extrinsic In : Si - Ga : Si photoconductor array families in VLSI version. The dotted lines 37 are the axes of six optical inputs. Backside illuminated array chips are effectively cooled by not shown silicon spacerframe soldering. Estimated cooling load without heat dissipation in the arrays is less than 1 watt.

The same cold station concept can be used for panoramic three-color, real-time spectral discrimination. A stack of three hexagonal silicon blocks accommodating three sets of infrared arrays for three spectral bands within the 3 - 5 $\mu$m atmospheric window are temperature biased by only one double-stage Sterling engine with less than 3 watt cooling power. The remarkably low overall heat load of a number of 18 area detector arrays allows for small-sized infrared receivers with simple peripheral heat dissipation mechanism.

The silicon heat transfer element of the invention is most suited to rapid cool down and to efficient temperature control which is illustrated by some practical examples of different package types. Quoted numerical values regard the silicon material used in the Fig 1 configuration.

The cold station of the described panoramic, three-color infrared receiver with mounting areas of 2 cm$^2$ for each array, has a thermal heat mass of 6000 joules for cooling from 300 to 60 K but requires only 7 joules per degree for further cooling which favors precise temperature feedback control.

Both thermal resistance and thermal capacity in silicon drop drastically with decreasing temperature to very small values in the cryogenic range: a silicon block of 1 cm length and 1 cm$^2$ cross section, sealed into a coldfinger tube, requires less than 300 joules for cool down to 80 K; its thermal resistance x capacity product at 80 K is less than 50 msec and it is less than 10 msec at 50 K.

The combination of minimum heat power loss in the package and the small thermal impedances in the innovative heatpath from electron device to cooler enables a most economical cooler operation. During cool down time the cooler works at full heat power rate. When steady state temperature conditions are reached, the very small thermal impedance of the load allows tight thermal feedback control and power is switched down to below-nominal heat power regime which leads to reduced input power dissipation, to low microphonics interference levels in the electron device and less mechanical wear which improves cooler life expectancy.

The striking dynamic thermal characteristics make silicon an advantageous heat transfer material also in applications where rapid cool down is a premium requisite.

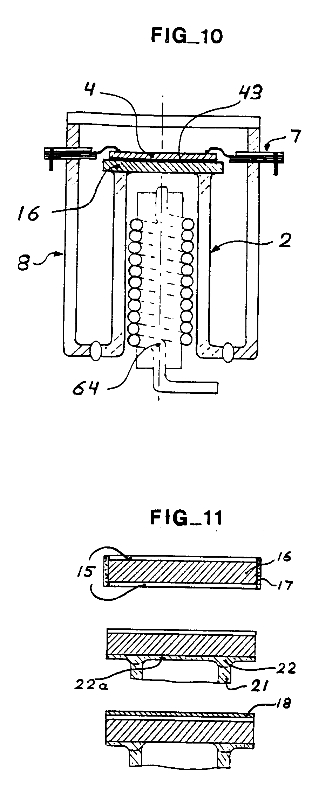

Fig 10 shows schematically a package suited to fast device cooling, consisting of the coldfinger 2 which is closed by a sealed silicon disc 16 and an outer embodiment with incorporated feedthrough component 7. The coldfinger glass tube has an inner precision bore of 5.18 mm which fits a standard Joule Thompson minicooler 64. The electron device 4 is assembled to the silicon disc 16 with a solder preform 43.

Fig 11 explains the construction procedure of the silicon-glass seal for an illustrative numerical example. Most processes refer to those described by Fig 7. Starting material is a (111) oriented, 0.3 mm thick silicon wafer. Both sides are polished and thermally oxidised, 15. Disc 16 is ultrasonically drilled and damaged layer 17 is chemically removed. The disc is T-sealed, 22, to a Pyrex(TM) tube 21 with 0.5 mm wall thickness. Alternatively, canary glass for seal 22 and Kovar(TM) glass for tube 21 are used.

During sealing process, a thin glass layer 22a is often formed. A layer of for instance 5 μm thickness has a prohibitively high thermal resistance of about 0.2 degrees per watt and the layer 22a is therefore etched off with diluted (e.g. 15%) hydrofluoric acid. Annealing and reflection metallisation of the coldfinger are the same as for the Fig 7 version.

Thermal shock resistance of the T-seal is high and the same test criteria are applied as given in the construction procedure related to Figs 1, 2, 3, and 4. Layer 18 is a sputter deposited titanium-palladium-gold contact material for solder preform 43.

The thermal mass of disc 16 for cool down to 80 K is less than 4 joules. Cool down time is no more determined by the thermal resistance capacity impedance which would result in times less than 5 msec but by the thermal inertia of the cooler itself and by the mechanism of heat exchange with the liquified gas.

By comparison, a commercially available V-shaped, high-speed minicooler employs approximately 2.5 seconds to reach the liquid point of argon at 87 K and this proves the usefulness of package Fig 10 with the T-shaped silicon-glass seal coldfinger.

It is obvious that the electrical feedthrough component 7 of Figs 1, 2 and 10 may be constructed in metal-glass sealing technique and that the innovative heat transfer element in silicon-glass sealing technology may be applied to other Dewar concepts as for instance to those quoted in the aforegoing.

It is also obvious that the cryogen may be of a different type for example, a liquified gas with a heat exchange mechanism known as bulk cooling.

It also turns out from the disclosed invention that it may be extended to a variety of devices or components which are not of the solid state but which have to be efficiently cooled and which require a hermetically sealed embodiment as for example the active gas in $CO_2$-lasers.

Another application of the invention is for instance in devices which require efficient cooling of large surface areas as in cryopumps.

The aforementioned 10 cm (4-inch) silicon-glass transfer element proposes for construction of Dewar devices with particularly high heat power throughput which is evidence of the usefulness of the invention also for efficient high power heat exchangers.


## Claims

1. Vacuum container for cryogenically cooled electron device packaging comprising:

(a) an external encasement constituting a part of the boundary of the evacuated portion of the container and consisting of a generally cylindrical peripheral wall member and a cover member joining said peripheral wall member in perpendicular relationship

(b) a centre coldfinger module constituting another part of the boundary of the evacuated portion of the container and consisting of a tubular member (21), a solid body member (1) and a tube member (26) with said tubular member projecting axially into the space enclosed by said peripheral wall member and having an open end which forms part of a hermetic seal (25) to said tube member which joins said peripheral wall member in radially extending and generally coaxial relationship and with said solid body member being concentrically sealed (22) into the other end of said tubular member and having two exposed faces in perpendicular relationship to the axis of said tubular member with the one face projected into the evacuated portion of the container and the other face situated in the non-evacuated portion within said tubular member

(c) a carrier board member (3) having two parallel faces one of which being disposed on said solid body member within the evacuated portion of the container in sealing (31) relationship

the vacuum container being characterised by the fact that

(d) said solid body member (1) consists of a silicon material

(e) said carrier board member (3) consists of a silicon material

(f) said tubular member (21) consists of a glass material

(g) said solid body member to tubular member seal (22) is a silicon-glass seal

(h) said carrier board member and solid body member disposition (31) is a silicon-metal-silicon joint

2. Vacuum container as defined by claim 1 characterised by the fact that said silicon materials of said solid body member (1) and said carrier board member (3) are single crystal, (111) oriented, etch pit free silicon

3. Vacuum container as defined by claim 2 characterised by said silicon of said solid body member (1) having an impurity concentration of $10^{14}$ cm$^{-3}$ or less and of said carrier board member (3) having an impurity concentration of $10^{17}$ cm$^{-3}$ or less

4. Vacuum container as defined by claim 1 characterised by the fact that said solid body member (1) is a silicon rod with circular or rectangular cross-section with the one face which is projected from said silicon-glass seal (22) into the evacuated portion of the container being thermally oxidised and the other face being projected from said silicon-glass seal (22) into the inner of said tubular member (21)

5. Vacuum container as defined by claim 1 characterised by the fact that said solid body member (1) is a thin circular or rectangular silicon chip (16) and that said face situated in the evacuated portion of the container is thermally oxidised and the opposite face is joined to said tubular member (21) by means of said silicon-glass seal (22) in butted relationship

6. Vacuum container as defined by claim 1 characterised by the glass of said silicon-glass seal (22) being CORNING glass 7740 or CORNING glass 3320

7. Vacuum container as defined by claim 6 characterised by the fact that said CORNING glass 7740 is sealed to said tubular member (21) consisting of CORNING glass 7740 and that said CORNING glass 3320 is sealed to said tubular member (21) consisting of CORNING glass 7052

8. Vacuum container as defined by claims 1, 4 and 5 characterised by the fact that the surfaces of said tubular member (21), said thermally oxidised silicon solid member (1) and said silicon-glass seal (22) adjacent to the vacuum in the container are metallised by a sputter-deposited nichrome-gold or titanium-palladium-gold layer (23)

9. Vacuum container as defined by claim 1 characterised by the fact that said carrier board member (3) is a thermally oxidised and metallised (35) disc with a diameter to thickness ratio of 10 to 1 or less

10. Vacuum container as defined by claim 1 characterised by said tube member (26) consisting of KOVAR $^{(R)}$ or stainless steel 304

11. Vacuum container as defined by claim 4 characterised by the fact that on said face of said solid body (1) which is projected from said silicon-glass seal (22) into the inner of said tubular member (21) a stack of mesh spacers (61) is disposed in mechanical relationship to the adjacent tip of a cryogenic engine (6) with said mesh spacers (61) consisting of copper or gold wire or of Nylon thread

8

## Patentansprüche

1. Vakuumbehälter zum kryogenischen Kühlen einer Packung für eine elektronische Anordnung. bestehend aus:

   (a) einer äußeren, einen Teil der Begrenzung des evakuierten Behälterbereiches bildenden Ummantelung. bestehend aus einem. im allgemeinen zylindrischen, peripherischen Wandbauteil sowie aus einem mit dem genannten peripherischen Wandbauteil rechtwinklig verbundenen Deckelbauteil

   (b) einer mittig angeordneten, einen anderen Teil der Begrenzung des evakuierten Behälterbereiches bildenden und aus einem rohrförmigem Bauteil (21), einem Festkörperbauteil (1), sowie einem Rohrbauteil (26) zusammengesetzten Kühlfingerbaueinheit, deren genanntes rohrförmiges Bauteil achsial in das genannte peripherische Wandbauteil hineinragt. an seinem einen offenen Ende mit dem genannten Rohrbauteil, welcher seinerseits nach ausen hin mit dem genannten peripherischen Wandbauteil, im allgemeinen in koaxialer Anordnung, verbunden ist, eine hermetische Dichtung (25) bildet, und an seinem anderen offenen Ende mit genanntem Festkörperbauteil eine konzentrische Verschmelzung (22) bildet, derart, daß die beiden offenen Flächen des genannten Festkörperbauteils senkrecht auf der Mittenachse des genannten rohrförmigen Bauteils stehen und daß eine der beiden Flächen in den evakuierten Behälterbereich hineinragt, während die andere Fläche im nicht evakuierten Teil des genannten rohrförmigen Bauteils liegt

   (c) einer Trägerplatte (3), deren eine der beiden parallelen Seiten mit dem genannten Festkörperbauteil innerhalb des evakuierten Behälterbereiches in dichter Zusammenfügung (31) angeordnet ist

   DADURCH GEKENNZEICHNET, daß

   (d) das genannte Festkörperbauteil (1) aus einem Siliziummaterial besteht

   (e) die genannte Trägerplatte (3) aus einem Siliziummaterial besteht

   (f) das genannte rohrförmige Bauteil (21) aus einem Glasmaterial besteht

   (g) die genannte Verschmelzung (22) des genannten Festkörperbauteils und des genannten rohrförmigen Bauteils eine Silizium-Glas Verschmelzung ist

   (h) die genannte Zusammenfügung (31) der genannten Trägerplatte und dem genannten rohrförmigen Bauteil eine Silizium-Metall-Silizium Verbindung ist

2. Vakuumbehälter gemäß Anspruch 1, DADURCH GEKENNZEICHNET, daß das genannte Siliziummaterial des genannten Festkörperbauteils (1) und der genannten Trägerplatte (3) einkristallines, (111)-orientiertes, versetzungsfreies Silizium ist

3. Vakuumbehälter gemäß Anspruch 2, DADURCH GEKENNZEICHNET, daß das genannte Silizium des genannten Festkörperbauteils (1) eine Verunreinigungskonzentration von 10E14 pro cm^3 oder weniger und dasjenige der genannten Trägerplatte (3) eine Verunreinigungskonzentration von 10E17 pro cm^3 oder weniger besitzen

4. Vakuumbehälter gemäß Anspruch 1, DADURCH GEKENNZEICHNET, daß das genannte Festkörperbauteil (1) ein Siliziumstab mit kreisförmigem oder rechteckigem Querschnitt ist, dessen eine, von der genannten Silizium-Glas Verschmelzung (22) in den evakuierten Behälterbereich hineinragende Fläche thermisch oxidiert ist und dessen andere Fläche von der genannten Silizium-Glas Verschmelzung (22) in das Innere des genannten rohrförmigen Bauteils hineinragt

5. Vakuumbehälter gemäß Anspruch 1, DADURCH GEKENNZEICHNET, daß das genannte Festkörperbauteil (1) ein dünnes, kreisförmiges oder rechteckiges Siliziumscheibchen ist, dessen eine, von der genannten Silizium-Glas Verschmelzung (22) in den evakuierten Behälterbereich hineinragende Fläche thermisch oxidiert ist und dessen gegenüberliegende Fläche mit dem genannten rohrförmigen Bauteil (21) mittels genannter Silizium-Glas Verschmelzung (22) stoßförmig verbunden ist

6. Vakuumbehälter gemäß Anspruch 1, DADURCH GEKENNZEICHNET, daß das Glasmaterial der genannten Silizium-Glas Verschmelzung (22) vom Typ CORNING 7740 oder CORNING 3320 ist

7. Vakuumbehälter gemäß Anspruch 6, DADURCH GEKENNZEICHNET, daß das genannte CORNING Glas 7740 mit dem genannten, aus CORNING Glas 7740 bestehendem, rohrförmigen Bauteil (21) und das genannte CORNING Glas 3320 mit dem genannten, aus CORNING Glas 7052 bestehendem, rohrförmigen Bauteil (21) verschmolzen sind

8. Vakuumbehälter gemäß Ansprüchen 1, 4 und 5, DADURCH GEKENNZEICHNET, daß die innerhalb des Vakuumbehälters liegenden Oberflächen des genannten rohrförmigen Bauteils (21), des genannten, thermisch oxidierten Festkörperbauteils (1) und der genannten Silizium-Glas Verschmelzung (22), mittels Katodenzerstäubung von Nickel-Chrom-Gold oder Titan-Palladium-Gold metallisiert sind

9. Vakuumbehälter gemäß Anspruch 1, DADURCH GEKENNZEICHNET, daß die genannte Trägerplatte (3) eine thermisch oxidierte und metallisierte Scheibe mit einem Durchmesser/Dickenverhältnis von 10 zu 1 oder weniger ist

10. Vakuumbehälter gemäß Anspruch 1, DADURCH GEKENNZEICHNET, daß das genannte Rohrbauteil (26) aus KOVAR oder rostfreiem Stahl 304 besteht

11. Vakuumbehälter gemäß Anspruch 4, DADURCH GEKENNZEICHNET, daß auf derjenigen genannten Fläche des genannten Festkörperbauteils (1), die von der genannten Silizium-Glas Verschmelzung (22) in das Innere des genannten rohrförmigen Bauteils (21) hineinragt, ein, das benachbarte Ende einer kryogenischen Maschine (6) mechanisch verbindender Stapel maschenförmiger Distanzstücke (61) angeordnet ist, worin die genannten maschenförmigen Distanzstücke (61) aus Kupfer- oder Golddraht oder aus Nylonfäden bestehen.

## Revendications

1. Récipient à vide pour le refroidissement cryogénique d'un empaquetage pour dispositif électronique, qui comprend:
   (a) une protection extérieure qui constitue une part du récipient à vide et formé d'une paroi périphérique, en général cylindrique et d'un couvercle perpendiculairement connexe à cette paroi périphérique
   (b) un doigt centrale froid qui constitue une autre part du récipient à vide et formé d'un élément tubulaire (21), un corps solide (1) et un tube (26) avec élément tubulaire projeté axialment sur cette paroi périphérique ayant une ouverture qui constitue part d'une soudure hermétique (25) avec ce tube (26) unit cette paroi périphérique en extension lequel radiale et généralment en relation coaxiale et avec ce dit corps solide (1) concentriquement soudé (22) à l'ouverture opposée de ce tubulaire ayant deux faces exposées en relation perpendiculaire à l'axe de ce même élément tubulaire avec une face projetée sur le côté à vide du récipient et l'autre face située sur le côté non à vide de l'élément tubulaire
   (c) un support (3) ayant deux faces parallèles dont une connexe à ce dit corps solide du côté à vide du récipient avec soudure (3)
   tel récipient est caractérisé par:
   (d) susdit corps solide (1) formé d'un matériel de silicium
   (e) susdit support (3) formé d'un matériel de silicium
   (f) susdit élément tubulaire (21) formé de matériel en verre
   (g) susdite jointure (22), entre le corps solide et l'élément tubulaire, est une soudure de silicium-verre
   (h) susdite jointure (31), entre le support (3) et le corps solide (1), est de silicium-métal-silicium

2. Récipient à vide selon la revendication 1 caractérisé par le fait que ce dits matérieux de silicium de ce corps solide (1) et de susdit support (3) sont des silicium mono-cristalin, orienté (111), exempt de dislocations

3. Récipient à vide selon la revendication 2 caractérisé par ce susdit silicium du corps solide (1) ayant une concentration d'impurité de 10E14 cm$^{-3}$ , ou inférieur, et ce susdit support (3) ayant une concentration d'impureté de 10E17 cm$^{-3}$, ou inférieur

4. Récipient à vide selon la revendication 1 caractérisé par le fait que ce corps solide (1) est une barre de silicium avec section circulaire, ou rectangulaire, avec cette face laquelle est projetée par cette soudure de silicium-verre (22) dans la position du récipient à vide, étant thermiquement oxydé et l'autre face étant projetée par telle soudure de silicium-verre (22) a l'intérieur de tel élément tubulaire (21)

5. Récipient à vide selon la revendication 1 caractérisé par le fait que ce dit corps solide (1) est un mince (16) de silicium circulaire ou rectangulaire et telle face, située du côté du récipient à vide, est thermiquement oxydé et le côté opposé est uni à cet élément tubulaire (21) par une soudure de silicium-verre (22) en forme de T

6. Récipient à vide selon la revendication 1 caractérisé par le verre de telle soudure (22) de silicium-verre, étant un verre du type CORNING 7740 ou un verre du type CORNING 3320

7. Récipient à vide selon la revendication 6 caractérisé par le fait que tel verre du type CORNING 7740 est soudé à cet élément tubulaire (21) étant formé par du verre du type CORNING 7740 et tel verre du type CORNING 3320 est soudé à cet élément tubulaire (21) étant formé par du verre du type CORNING 7052

8. Récipient à vide selon les revendications 1, 4 et 5 caractérisé par le fait que les superficies du susdit élément tubulaire (21) de susdit corps solide thermiquement oxydé (1) et de susdite soudure de silicium-verre (22), adjacent au vide du récipient, sont métalisés par une couche (23) de nikel-chrome-or ou titane-palladium-or déposées grâce le sputtering

9. Récipient à vide selon la revendication 1 caractérisé par le fait que tel support (3) est un disque thermiquemement oxydé et métalisé (35) avec un rapport de diametre-épaisseur 10 à 1 ou inférieur

10. Récipient à vide selon la revendication 1 caractérisé par le fait que susdit élément tubulaire (26) est de consistence de KOVAR ou ACIER INOX 304

11. Récipient à vide selon la revendication 4 caractérisé par le fait que sur la face de ce dit corps solide (1), qui est projeté par cette soudure silicium-verre (22) à l'intérieur de tel élément tubulaire (21) une couche d'épaisseurs à réseau (61), est mis en relation méccanique au sommet de l'adjacente machine criogénique (6) avec ces épaisseurs à réseau (61) étant formé de fils de cuivre ou d'or ou fils de NYLON

FIG_1

FIG_4

FIG_3

FIG_2

FIG_5

14

1

21

FIG_6

14

19

21

FIG_7

A

11

1

C

22

21

B

12

D

23

13

FIG_8

41

39

1

21

FIG_9

37

38

36

1

21

## FIG_10

## FIG_11